# EUROPEAN PATENT APPLICATION

(11) **EP 4 531 106 A1**
(43) Date of publication of application: **02.04.2025**
(21) Application number: 23200701.3
(22) Date of filing: 29.09.2023
(51) Int. Cl.: H01L 27/105, G11C 19/28, H01L 29/423

(54) **WORD LINE CONTACTING SCHEME IN AN INTEGRATED THREE-DIMENSIONAL CHARGE-COUPLED DEVICE MEMORY**

(71) Applicant: Imec VZW, 3001 Leuven (BE)
(72) Inventor: Mahato, Swaraj Bandhu, 3012 Wilsele (BE); Rosmeulen, Maarten, 9000 Gent (BE)
(74) Representative: Roth, Sebastian

(57) **Abstract**

The present disclosure relates to a charge-coupled device (CCD) memory. In particular, the disclosure provides a design and a contacting scheme for a three-dimensional (3D) integrated CCD memory, which may be a multi-phase CCD memory. The 3D CCD memory comprises a stack including a plurality of gate layers and spacer layers, which are alternatingly arranged one on the other along a first direction; a plurality of semiconductor-based channels extending in the stack. The channels form, in combination with the gate layers and one or more gate dielectric layers, a plurality of strings of charge storage capacitors operable as a plurality of CCD registers. A plurality of contact vias extend in the stack. Each contact via is associated with one group of a plurality of disjoint groups of the gate layers, and is electrically connected to all the gate layers of the group it is associated with, wherein at least one of the groups comprises two or more gate layers.

## Description

### TECHNICAL FIELD

The present disclosure relates to a charge-coupled device (CCD) memory. In particular, the disclosure provides a design and a word line contacting scheme for a three-dimensional (3D) integrated CCD memory, which may be a multi-phase CCD memory.

### BACKGROUND

Today, data creation is skyrocketing, propelled by data-driven technologies. This has left the memory pyramid in urgent need of transformation. In particular, the gap between low-cost storage memory and high-speed working memory has to be bridged. The gap results from a mismatch between the increasing need to compute growing amounts of data versus trends in the underlying memory technologies. The increasing demand and the approaching scaling "brick wall" of conventional dynamic random access memory (DRAM) has prompted the search for new types of memory.

For instance, various types of so-called storage class memory (SCM) have been proposed, but no completely satisfactory solution has emerged yet. The available alternatives for DRAM lack either scalability like phase change memory (PCM), or lack power efficiency like magnetic random access memory (MRAM), or lack cycling capability like low-latency NAND memory.

CCD-based SCM has emerged as a fundamentally new class of memory, and is considered a good candidate for bridging the memory gap, while having a significant cost advantage over DRAM. CCDs lack the byte-addressability, which is conventionally required for RAM. One idea employed in this disclosure is to trade this byte-addressability for lower costs.

However, a 3D CCD-based memory array architecture would be needed to realize the high memory cell densities that are desired.

### SUMMARY

Therefore, this disclosure aims to provide a 3D CCD memory with a high memory cell density.

An exemplary 3D CCD memory, which forms the basis of the solutions of disclosure, comprises a plurality of CCD registers, wherein each CCD register is formed based on a semiconductor-based channel that extends in a stack of alternatingly stacked gate and dielectric layers. Each channel forms, in combination with the gate layers and at least one dielectric layer, a string of charge storage capacitors operable as a CCD register.

To reduce bit cost and to increase the density in such an exemplary 3D CCD memory, a direct way would be to add more layers to the stack, i.e., to increase the number of memory cells per CCD register. Further, a way to access the gate layers of the stack could be to realize a staircase-like structure, wherein each step of the staircase-like structure could be connected to a top metal via landing a contact on the step. However, adding more layers to the stack will increase the vertical level of the staircase-like structure, and eventually the area overhead due to staircase would increase too much.

In particular, many gate layers would be required for designing a 3D multi-phase CCD memory. A multi-phase CCD memory may incorporate multiple individual gate electrodes in a unit memory cell, each of which may require a separate input clock signal, in order to properly transport accumulated charge through the CCD register. Moreover, same phases for all memory cells need to be connected together.

Accordingly, it is challenging to balance memory density, manufacturing throughput and process complexity/cost when building such a memory.

In view of the above, a particular objective of this disclosure is to provide a contacting scheme to contact the gate layers of a high-density 3D multi-phase CCD memory, without overly increasing the area overhead and the manufacturing complexity.

This and other objectives are achieved by the solutions of this disclosure as provided in the independent claims. Advantageous implementations are defined in the dependent claims.

A first aspect of this disclosure provides an integrated 3D CCD memory comprising: a stack including a plurality of gate layers and spacer layers, which are alternatingly arranged one on the other along a first direction; a plurality of semiconductor-based channels extending in the stack; wherein the channels form, in combination with the gate layers and one or more gate dielectric layers, a plurality of strings of charge storage capacitors operable as a plurality of CCD registers; and a plurality of contact vias extending in the stack; wherein each contact via is associated with one group of a plurality of disjoint groups of the gate layers, and is electrically connected to all the gate layers of the group it is associated with, wherein at least one of the groups comprises two or more gate layers.

The charge storage capacitors of a string may be connected in series to form the CCD register. The charge storage capacitors may be MOS capacitors One or a number of storage capacitors in the CCD register may be considered a memory cell of the CCD memory.

By integrating the CCD registers in the 3D arrangement - i.e., by building the stack of the gate layers and the spacer layers along the first direction, and by forming the channels in this stack, preferably aligned vertically along the first direction - a high density like in 3D NAND Flash can be achieved. Thus, the costs (per stored bit) may become low. The CCD memory of the first aspect can be used as SCM, under the premise that byte-addressability can be omitted. The CCD memory may provide high speeds, good reliability, nearly unlimited cycling, and low power consumption.

Each disjoint group of the plurality of groups may be contacted with one or more contact vias. All layers in each group are connected together. There may be multiple groups comprising two or more gate layers. For instance, each of the disjoint groups may comprise two or more gate layers. Multiple CCD registers formed in the stack share the same groups of gate layers. Each group may be associated with a certain clocking phase of multiple clocking phases, if the 3D CCD memory is a multi-phase memory. The clocking phases for all CCD registers may be connected together.

The contacting scheme described above allows contacting the gate layers with a smaller area overhead than in an exemplary 3D CCD memory. Thus, the contacting scheme allows better balancing the memory density, the manufacturing throughput and the fabrication process complexity.

In an implementation of the 3D CCD memory, each contact via is associated with a different group of the gate layers.

In an implementation of the 3D CCD memory, at least one contact via extends through the gate layers of the group it is associated with.

In an implementation of the 3D CCD memory, at least one contact via extends through one or more gate layers of at least one group it is not associated with, wherein the contact via is electrically isolated from the one or more gate layers of the at least one group it is not associated with.

In an implementation of the 3D CCD memory, at least one contact via extends through the gate layers of the group it is associated with, and also extends through one or more gate layers of at least one group it is not associated with, wherein the contact via is electrically isolated from the one or more gate layers of the at least one group it is not associated with.

In an implementation of the 3D CCD memory, the one or more gate layers of the at least one group the contact via is not associated with have a larger opening, through which the contact via extends, than the gate layers of the group the contact via is associated with.

The above implementations enable a smaller area overhead for providing multiple contact vias for contacting multiple different groups of the plurality of disjoint groups of gate layers.

In an implementation of the 3D CCD memory, the stack has a staircase-like shape comprising multiple steps that spread out into a second direction perpendicular to the first direction, each step comprising multiple gate layers and the topmost gate layer of each step belonging to the same group; and the topmost gate layer of each step is electrically connected to the same contact via, which lands on a top surface of each topmost gate layer.

In an implementation of the 3D CCD memory, the contact via passes the other gate layers of the multiple steps, and is electrically isolated by a spacer from each of these other gate layers.

In an implementation of the 3D CCD memory, each step has staircase-like structure comprising multiple sub-steps that spread out into a third direction perpendicular to the first and second direction, each sub-step comprising one gate layer, and gate layers of different sub-steps belonging to different groups; and each sub-step of the step is electrically connected by a different contact via, which lands on a top surface of the gate layer of said sub-step.

The above staircase-based implementations enable a smaller area overhead for providing multiple contact vias for contacting multiple different groups of the plurality of disjoint groups of gate layers.

In an implementation of the 3D CCD memory, a set of the plurality of gate layers of the stack is operable as a plurality of clocking phases of the plurality of CCD registers, in order to transport charge along the CCD registers; and each group of gate layers is associated with a different clocking phase of the plurality of clocking phases.

Thus, an efficient way of connecting and providing the signals to the different CCD clocking phases is provided. The 3D CCD memory may be a multi-phase CCD memory having a small footprint, while still having a high memory density. Notably, each CCD register may also need additional signals to be connected to other gates layers than the set of gate layers, which is associated with the clocking phases. For instance, an input transfer gate and an output transfer gate at, respectively, the input and output of the CCD register. Or, for instance, a back barrier or an output summing well at the output of the CCD register. Typically, each such signal is connected to a single gate layer only, so no special contacting scheme is needed in these cases.

In an implementation of the 3D CCD memory, the multiple gate layers of each step comprise one gate layer for each of the plurality of clocking phases.

In an implementation of the 3D CCD memory, the plurality of contact vias comprises a first contact via connected to a first group of gate layers comprising gate layers associated with a first clocking phase; and a second contact via connected to a second group of gate layers comprising gate layers associated with a second clocking phase.

In an implementation of the 3D CCD memory, the plurality of contact vias further comprises: a third contact via connected to a third group of gate layers comprising gate layers associated with a third clocking phase; and/or one or more further contact vias respectively connected to one or more further groups of gate layers respectively comprising gate layers associated with one or more further clocking phases.

According to the above implementations, an efficient contacting scheme for a multi-phase 3D CCD memory is provided.

In an implementation of the 3D CCD memory, the stack has a first region and a second region adjacent to the first region, wherein the CCD registers are located in the first region and the contact vias are located in the second region.

A second aspect of this disclosure provides a method for fabricating an integrated 3D CD memory, the method comprising: forming a stack including a plurality of gate layers and spacer layers, which are alternatingly arranged one on the other along a first direction; forming a plurality of semiconductor-based channels in the stack, wherein the channels form, in combination with the gate layers and one or more gate dielectric layers formed in the stack, a plurality of strings of charge storage capacitors operable as a plurality of CCD registers; and forming a plurality of contact vias in the stack; wherein each contact via is associated with one group of a plurality of disjoint groups of the gate layers, and is electrically connected to the gate layers of the group it is associated with.

The method of the second aspect achieves the same advantages as the device of the first aspect and maybe extended by respective implementations as described above for the 3D CCD memory of the first aspect.

In an implementation, the method further comprises: forming, for each contact via, a respective opening through the stack; structuring the respective opening, so that the respective opening is smaller for one group of gate layers than for the other groups of gate layers; forming the contact via in the respective opening, wherein the contact via is electrically connected to the gate layers of the group it is associated with because of the smaller opening in these gate layers, and is electrically isolated from the gate layers of the other groups because of the larger opening in these gate layers; wherein respective openings for different contact vias have the smaller opening in gate layers of different groups.

This implementation achieves a contacting scheme with a low area overhead.

In summary, this disclosure proposes a design and contacting scheme for a 3D CCD memory, in particular, a multi-phase 3D CCD memory. The contacting scheme may include a staircase-like architecture and/or an architecture, wherein the contact vias pass through the gate layer stack. The contact vias may be formed before a replacement metal gate (RMG) step of a fabrication process of the 3D CCD memory.

### BRIEF DESCRIPTION OF THE DRAWINGS

The above described aspects and implementations are explained in the following description of embodiments with respect to the enclosed drawings:
- FIG. 1: shows a 3D CCD memory according to this disclosure.
- FIG. 2: shows a first exemplary contacting scheme for a 3D CCD memory according to this disclosure.
- FIG. 3: shows a second exemplary contacting scheme for a 3D CCD memory according to this disclosure.
- FIG. 4: shows further details of the second exemplary contacting scheme.
- FIG. 5: shows further details of the second exemplary contacting scheme.
- FIG. 6: shows further details of the second exemplary contacting scheme.
- FIG. 7: shows a method according to this disclosure for processing a 3D CCD memory.
- FIG. 8: shows process steps for realizing the first exemplary contacting scheme.
- FIG. 9: shows process steps for realizing the first exemplary contacting scheme.

### DETAILED DESCRIPTION OF EMBODIMENTS

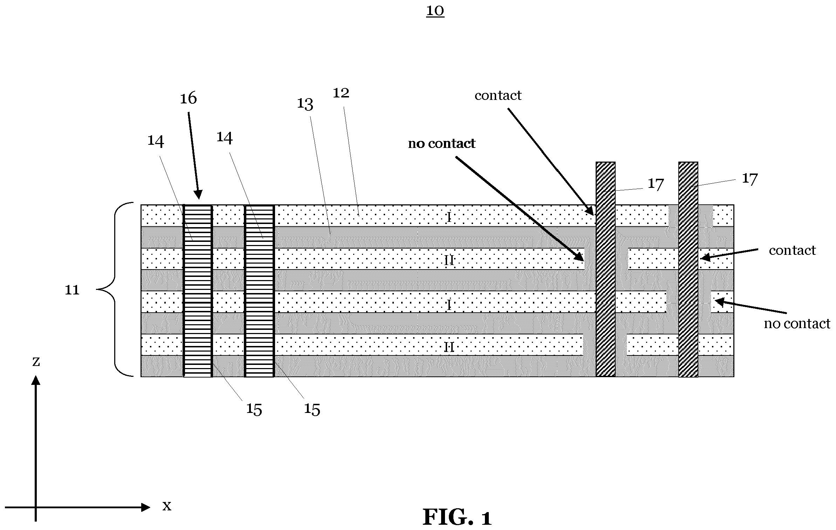

FIG. 1 shows an integrated 3D CCD memory 10 according to this disclosure. The 3D CCD memory 10 can be an SCM, for instance, a block-addressable SCM. The CCD memory 10 may be used as a DRAM replacement in some of its use cases, or as an improved substitute for various other types of SCM. For instance, the CCD memory 10 of this disclosure may provide better scalability than a PCM, and/or may have a better power efficiency than a MRAM, and/or may have a better cycling capability than low-latency NAND memory.

The CCD memory 10 comprises a layer stack 11, which includes a plurality of gate layers 12 and spacer layers 13, which are alternatingly arranged one on the other along a first direction. The gate layers 12 may be metal layers or other conductive layers. The spacer layers 13 may be dielectric layers or oxide layers or other insulating layers. The first direction corresponds to the vertical direction in FIG. 1, and may particularly correspond to a first axis of a coordinate system, for instance, the z-axis as indicated. The stack 11 may either start with a gate layer 12 or with a spacer layer 13 (as the bottom-most layer of the stack), for instance, provided or grown on a substrate. The layer stack 11 may likewise end with a gate layer 12 or with a spacer layer 13 (as the top-most layer of the stack 11, e.g., farthest away from the substrate), and the illustrated stack 11 of FIG. 1 is just an example.

The CCD memory 10 further comprises a plurality of semiconductor-based channels 14 extending in the stack 11. These channels 14 form, in combination with the gate layers 12 and with one or more gate dielectric layers 15 - which may extend through the stack adjacent to the semiconductor-based channels 14, respectively - a plurality of strings of charge storage capacitors. These charge storage capacitors are operable as a plurality of CCD registers 16. Notably, each gate layer 12 may surround one or more of the semiconductor-based channels 14. An end (bottom) of each CCD register 16 may comprise an output transfer-gate and may ultimately be connected to a readout circuit. The other end (top) may comprise an input transfer-gate and may be connected to a bit line.

The semiconductor-based channels 14 may respectively be made of a semiconductor oxide material. For instance, the semiconductor oxide material may comprise at least one of indium gallium zinc oxide (IGZO), indium tin oxide (ITO), and indium zinc oxide (IZO), or another wide-bandgap oxide semiconductor. Such wide-bandgap oxide semiconductors allow achieving an increased retention time of the CCD memory 10. The semiconductor-based channels 14 may also be made of a silicon-based semiconductor material or may be made of a III-V semiconductor material.

In order to fabricate the plurality of channels 14, a plurality of holes may formed through the entire layer stack 11 (after the stack 11 has been grown, for example, on a substrate), and may then be filled or plugged with the semiconductor-based material, for example, with the semiconductor oxide material like IGZO, along with the material for forming the one or more gate dielectric layers 15. The gate dielectric layers 15 may each be arranged between one of the semiconductor-based channels 14 and at least one of the gate layers 12. Thereby, the strings of charge storage capacitors connected together as a CCD register 16 are formed.

The semiconductor-based channels 14 may extend along the first direction, i.e., along the z-axis, and/or may extend perpendicular to the parallel surfaces of the gate layers 12 and spacer layers 13. The semiconductor-based channels 14 may be straight in the stack 11, or may have a bend in the stack 11, in particular, they could respectively have a U-shape. The semiconductor-based channels 14 may be full channels or macaroni-type channel (hollow channels, e.g., filled with a dielectric material).

The CCD memory 10 further comprises a plurality of contact vias 17, which extend in the stack 11. The contact vias 17 may be metal vias, and may extend along the first direction and/or parallel to the channels 14. Each contact via 17 is associated with one group of a plurality of disjoint groups of the gate layers 12 - note that two groups denoted I and II are shown in FIG. 1 just as an example. A least one of the groups comprises two or more gate layers 12. In an example all the disjoint groups include at least two gate layers 12. The groups being disjoint means that any gate layer 12 in one group is not included in any other group. That is, the gate layers 12 of each group are elements of no other group. Each contact via 17 is electrically connected to all the gate layers 12 of the group it is associated with. Each contact via 17 may be associated with a different group. However, more than one contact via 17 can be associated with the same group. Each contact via 17 may be isolated from or at least not connected to gate layers of one or more groups it is not associated with.

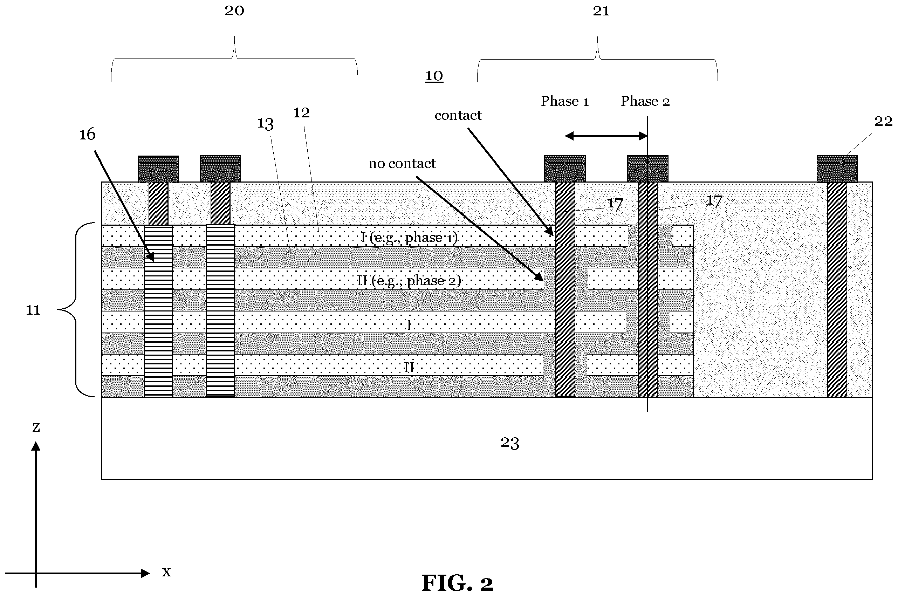

FIG. 2 shows a first exemplary contacting scheme of a 3D CCD memory 10 according to this disclosure, which may for example build on the 3D CCD memory 10 shown in FIG. 1. Same elements in FIG. 1 and 2 are labelled with the same reference signs and may be implemented likewise.

The first exemplary contacting scheme includes that each of one or more contact vias 17 of the plurality of contact vias 17 extends through the gate layers 12 of the group it is associated with - again groups I and II are shown as example. Each contact via 17 may extend through its associated gate layers 12. Further, each of the contact vias 17 extends also through one or more gate layers 12 of at least one group it is not associated with, and the contact via 17 is electrically isolated from the one or more gate layers 12 of the at least one group it is not associated with. For example, two contact vias 17 are shown in FIG. 2. One of these contact vias 17 extends through and is connected to the gate layers 12 associated with group I, and extends through but is isolated from the gate layers 12 of group II. That is the contact via 17 makes electrical contact to the gate layers 12 of group I, but does not make electrical contact to the gate layers of group II. The other contact via 17 extends through and is connected to the gate layers 12 associated with group II, and extends through but is isolated from the gate layers 12 of group I.

This may be realized by differently-sized openings in the gate layers 12 of the stack 11, through which the contact vias 17 extend. For example, the gate layers 12 of the group the contact via 17 is not associated with have a larger opening than the gate layers 12 of the group the contact via 17 is associated with. For example, the contact via 17 in FIG. 2 that is associated with group I extends through the gate layers 12 of group I and through the gate layers of group II. However, since the gate layers 12 of group II have a larger opening around the contact via 17, the contact via 17 can be isolated from the gate layers 12 of group II, e.g., by a dielectric material.

Notably, in FIG. 2 it is indicated that the gate layers 12 of group I may be of a first clocking phase (phase 1), and the gate layers of group II may be of a second clocking phase (phase 2). Generally, at least some of plurality of gate layers 12 of the stack 11 are operable as a plurality of clocking phases of the plurality of CCD registers 16, in order to transport charge along the CCD registers 16. Each group of gate layers 12 may be associated with a different clocking phase - in the example of FIG. 2 with phase 1 and phase 2 - of the plurality of clocking phases.

It can also be seen in FIG. 2 that the stack 11 may have a first region 20 and a second region 21 next to the first region 20. The CCD registers 16 are located in the first region 20, which may thus also be referred to as memory core. The contact vias 17 are located in the second region 21, which may be referred to as contact region.

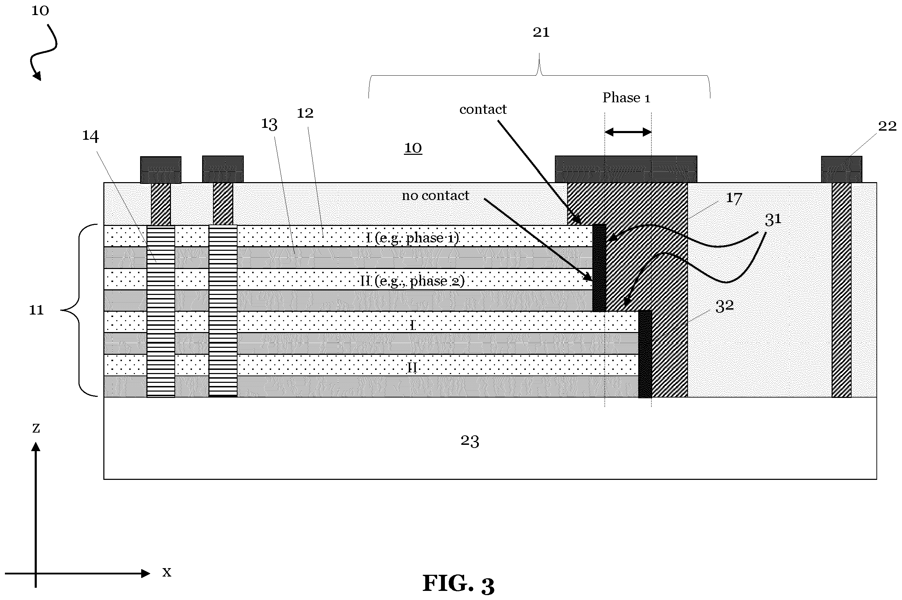

FIG. 3 shows a second exemplary contacting scheme of a 3D CCD memory 10 according to this disclosure, which may for example build on the 3D CCD memory 10 shown in FIG. 1. Same elements in FIG. 1 and 3 are labelled with the same reference signs and may be implemented likewise.

FIG. 3 shows that the stack 11 can have a staircase-like shape. That is, the stack 11 may comprise multiple steps 31 that spread out into a second direction perpendicular to the first direction. The second direction may be along a second axis, for instance, the x-axis as indicated. Each step 31 is thus longer along/into the x-axis than the step 31 above it. Each step 31 comprises multiple gate layers 12. The topmost gate layer 12 of each step 31 belongs to the same group. For example, as shown in FIG. 3, the top-most gate layers 12 of the two shown steps 31 belong both to group I. The topmost gate layer 12 of each step 31 is electrically connected to the same contact via 17, which lands on an exposed top surface of the topmost gate layer 12. For example, the contact via 17 in FIG. 3 lands on the topmost gate layer 12 of the upper step 31 and also of the lower step 31, which both belong to group I.

Each contact via 17 may further pass the other gate layers 12 of the multiple steps 31, and may be electrically isolated by a spacer 32 from each of these other gate layers 12. For example, the contact via 17 in FIG. 3 passes the gate layers 12 of the two steps 31 that belong to group II, and is respectively separated from these gate layers 12 by the two spacers 32. That is the contact via 17 makes electrical contact only to the gate layers 12 of group I, but does not make electrical contact to the gate layers of group II.

It is further shown in FIG. 3 that each contact via 17 may be connected to a metal contact 22. Also each CCD register 16 may be connected to a metal contact and/or a via.

The gate layer staircase architecture is useful for a multi-phase 3D CCD memory, where - as shown in FIG. 3 - the groups I, II are associated with different clocking phases (phase 1, phase 2). Each gate layer 12 is or may be connected to a word line.

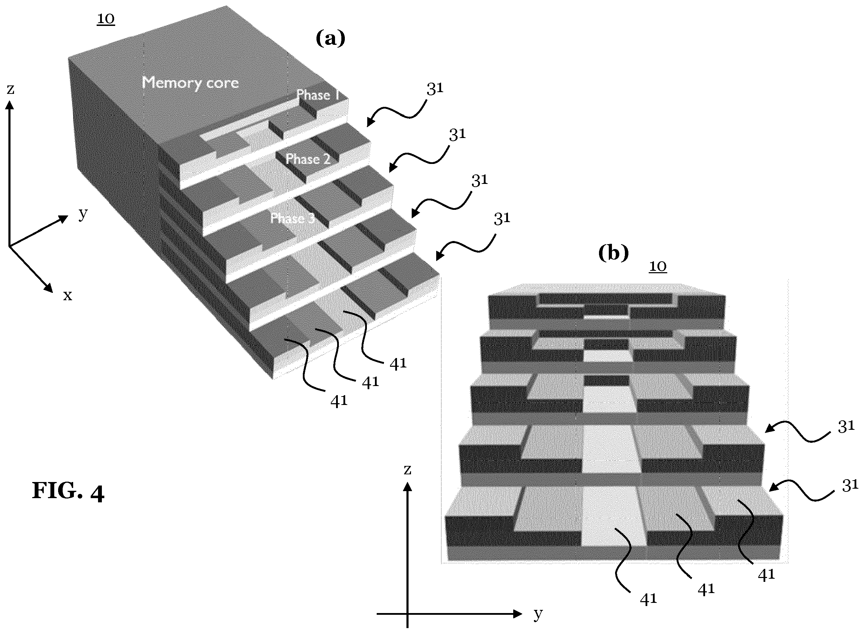

FIG. 4 shows further details of the second exemplary contacting scheme. Same elements of the 3D CCD memory 10 in FIG. 3 and 4 are labelled with the same reference signs. A 3D view of the 3D CCD memory 10 with the staircase-shape is depicted in FIG. 4

In particular, in the example of FIG. 4 the 3D CCD memory 10 is a 3-phase CCD memory. That is, each step 31 includes three gate layers 12, for three different clocking phases - phase 1, phase 2 and phase 3 in this example. The steps 31 extend in the x-direction.

In the y-direction, each step 31 is split from a single stack in the y-direction. That is, each step 31 itself also has staircase-like structure. Each step 31 thus comprises multiple sub-steps 41 that spread out along the y-axis as indicated. Each sub-step 41 comprises one gate layer 12, and the gate layers 12 of different sub-steps 41 belong to different groups of the plurality of disjoint groups. For instance, in FIG. 4 each sub-step 41 includes a gate layer 12 for phase 1, a further gate layer 12 for phase 2, and a further gate layer for phase 3. Area can be saved in the x-direction by making the staircase two-dimensional rather than one-dimensional. Along with that, the sub-steps in the y-direction give access to connect same clocking phases to a common back end of line (BEOL) metal through the contact vias 17.

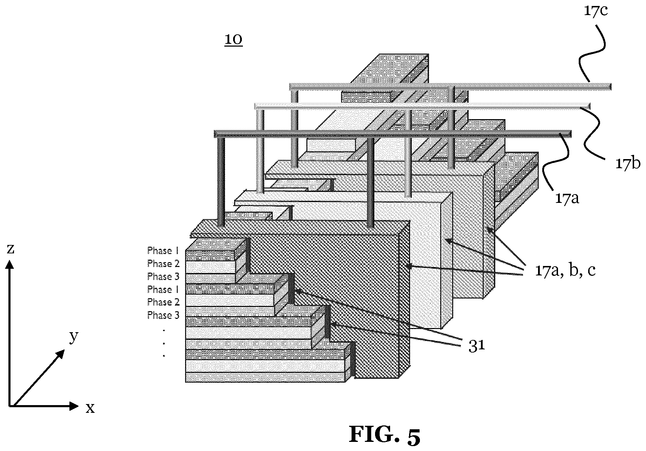

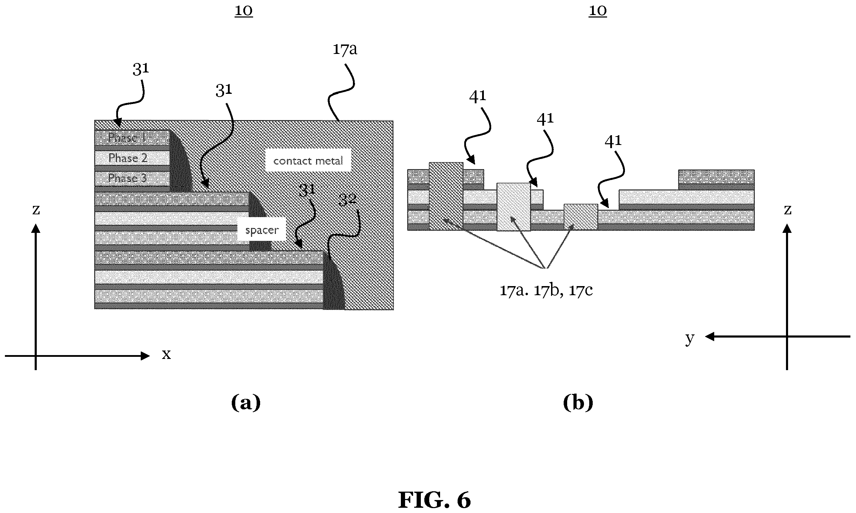

FIG. 5 and FIG. 6 show further details of the second exemplary contacting scheme. Same elements of the 3D CCD memory 10 in FIG. 4, 5 and 6 are labelled with the same reference signs.

As can be seen in FIG. 5 and FIG. 6(b), each sub-step 41 of each step 31 is electrically connected by a different contact via 17, which lands on a top surface of the gate layer 12 of said sub-step 41. In particular, a first contact via 17a is connected to the first group of gate layers 12 associated with clocking phase 1, a second contact via 17b is connected to a second group of gate layers 12 associated with clocking phase 2, and a third contact via 17c is connected to a third group of gate layers 12 associated with clocking phase 3. The 3D CCD memory 10 could comprise one or more further contact vias 17, which are respectively connected to one or more further groups of gate layers 12 respectively comprising gate layers 12 associated with one or more further clocking phases.

Making the staircase two-dimensional rather than one-dimensional - with the steps 31 and sub-steps 41- may save area, but the size of the staircase is still limited by the pitch of the contact vias 17. To improve this, a trench-based contact metal filling is proposed, wherein dedicated and controlled trencher are formed in the x-direction, which will expose same phases of every unit memory bit cells (a unit bit cell may have multiple phases/gate layers, e.g. for a 3-phase 3D CCD memory 10, each memory cell may be comprised of 3 phases and thus three gate layers 12). The trench is filled with metal for the contact vias 17, which electrically connect same clocking phases of each memory cell. The sidewall spacers 32 are formed on each step 31 of the staircase in the x-direction, as shown in FIG. 6(a), to isolate other stacked gate layers 12 (other phases) from the contact metal via 17. This contact scheme may be applied for all three sub-steps 41 (corresponding to different phases), which spread in the bit line direction (y-direction) as depicted in FIG. 6.

FIG. 6 particularly presents the x-direction and y-direction side view of the staircase structure of the 3D CCD memory 10. Using this staircase structure, all the same clocking phase of the 3D-CCD memory 10 can be electrically connected, which and mitigate the limitation of WL staircase scaling imposed by the traditional stair contact pitch.

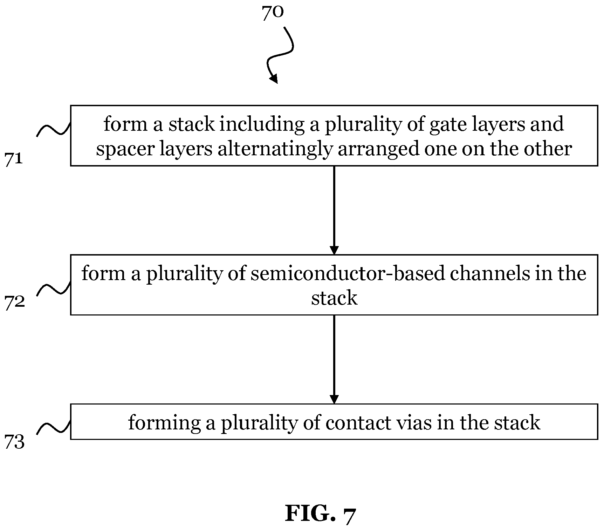

FIG. 7 shows a flow-diagram of a general method 70 for fabricating the 3D CCD, memory 10 of this disclosure, for instance, as shown in the previous figures. The method 70 comprises a step 71 of forming a stack 11 including a plurality of gate layers 12 and spacer layers 13, which are alternatingly arranged one on the other along the first direction. The method 70 further comprises a step 72 of forming a plurality of semiconductor-based channels 14 in the stack 11. The channels 14 form, in combination with the gate layers 12 and one or more gate dielectric layers 15 also formed in the stack 11, a plurality of strings of charge storage capacitors operable as a plurality of CCD registers 16. The method 70 further comprises a step 73 of forming a plurality of contact vias 17 in the stack 11. Each contact via 17 is associated with one group I, II of a plurality of disjoint groups I, II of the gate layers 12, and is electrically connected to the gate layers 12 of the group I, II it is associated with.

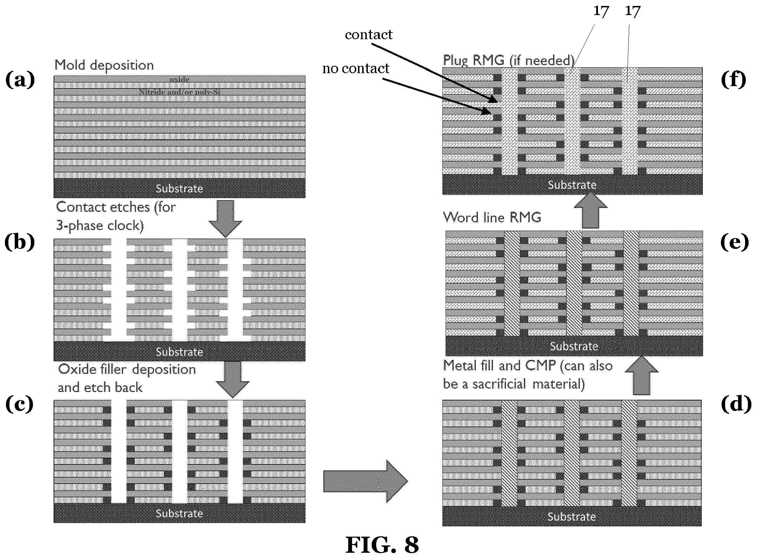

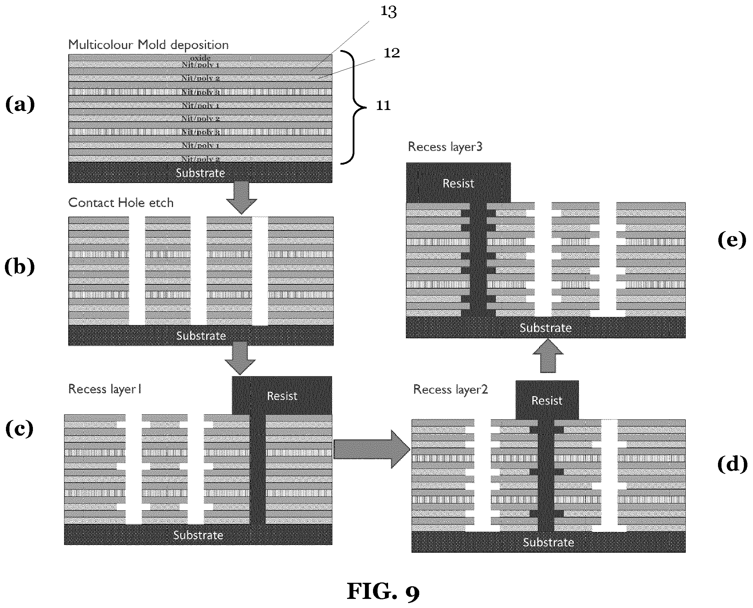

Along with the above-described solutions, this disclosure also proposes a specific process architecture for implementing the second exemplary contact scheme, wherein the contact vias 17 may be formed before RMG. FIG. 8 and 9 show the detailed process architecture.

This process architecture includes forming, for each contact via 17, a respective opening through the stack 11, and structuring the respective opening, so that the respective opening is smaller for one group of gate layers 12 than for the other groups of gate layers 12. This process also include forming the contact via 17 in the respective opening, wherein the contact via 17 is electrically connected to the gate layers (12) of the group it is associated with because of the smaller opening in these gate layers 12, and is electrically isolated from the gate layers 12 of the other groups because of the larger opening in these gate layers 12. Respective openings for different contact vias 17 thereby have the smaller opening in gate layers 12 of different groups.

An idea is to first put in place butted contact vias 17, and then do the RMG. The contact vias 17 can be fully in place including metallization before the RMG, as shown in FIG. 8(d). However, this may give problems with landing the RMG onto the metal plug connected to the contact vias 17. Alternatively, a plug in a sacrificial material may be used onto which the RMG can land. This material can then be removed after the RMG and replaced with metal, as shown in FIG. 8(f).

FIG. 8 shows the processing of the second exemplary contact scheme. One possible option is to do the memory-hole etch and fill it before the contact etch. However, the contact etch can also be done before. In the latter case, it may not be possible to be filled with metal initially, and a sacrificial plug may have to be used, as mentioned in Fig. 8(d). The challenging part is how to implement the contact etches (shown in Fig 8(b)) for multi-phase 3D-CCD memory. One possible way to process contact etches is shown in FIG. 9.

Here, before the RMG, a stack 11 is formed including a plurality of gate layers 12 and spacer layers 13, which are alternatingly arranged one on the other along the first direction. The plurality of the gate layers 12 are formed by multi-color mold deposition, wherein one group of a plurality of disjoint groups of the gate layers 12 formed with same material whereas different disjoint groups are formed with different materials for the gate layers 12. As depicted in Fig. 9, after a contact hole etch, recessing of gate layers in a group of a plurality of disjoint groups of the gate layers is performed. The recessing of the gate layers may be performed alternatively for each contact via 17, to form a respective opening through the stack 11, and to structure the respective opening, so that the respective opening is smaller for one group of gate layers 12 than for the other groups of gate layers 12.

In the claims as well as in the description of this disclosure, the word "comprising" does not exclude other elements or steps and the indefinite article "a" or "an" does not exclude a plurality. A single element may fulfill the functions of several entities or items recited in the claims. The mere fact that certain measures are recited in the mutual different dependent claims does not indicate that a combination of these measures cannot be used in an advantageous implementation.

## Claims

1. An integrated three-dimensional, 3D, charge-coupled device, CCD, memory (10) comprising:
a stack (11) including a plurality of gate layers (12) and spacer layers (13), which are alternatingly arranged one on the other along a first direction (z);
a plurality of semiconductor-based channels (14) extending in the stack;
wherein the channels (14) form, in combination with the gate layers (12) and one or more gate dielectric layers (15), a plurality of strings of charge storage capacitors operable as a plurality of CCD registers (16); and
a plurality of contact vias (17) extending in the stack (11);
wherein each contact via (17) is associated with one group (I, II) of a plurality of disjoint groups of the gate layers (12), and is electrically connected to all the gate layers (12) of the group (I, II) it is associated with, wherein at least one of the groups (I, II) comprises two or more gate layers (12).

2. The 3D CCD memory (10) of claim 1, wherein each contact via (17) is associated with a different group (I, II) of the gate layers (12).

3. The 3D CCD memory (10) of claim 1 or 2, wherein at least one contact via (17) extends through the gate layers (12) of the group (I, II) it is associated with.

4. The 3D CCD memory (10) of one of the claims 1 to 3, wherein at least one contact via (17) extends through one or more gate layers (12) of at least one group (I, II) it is not associated with, wherein the contact via (17) is electrically isolated from the one or more gate layers (12) of the at least one group (I, II) it is not associated with.

5. The 3D CCD memory (10) of the claims 3 and 4, wherein the one or more gate layers (12) of the at least one group (I, II) the contact via (17) is not associated with have a larger opening, through which the contact via (17) extends, than the gate layers (12) of the group (I, II) the contact via (17) is associated with.

6. The 3D CCD memory (10) of one of the claims 1 to 5, wherein:
the stack (11) has a staircase-like shape comprising multiple steps (31) that spread out into a second direction (x) perpendicular to the first direction (z), each step (31) comprising multiple gate layers (12) and the topmost gate layer (12) of each step (31) belonging to the same group (I, II); and
the topmost gate layer (12) of each step (31) is electrically connected to the same contact via (17), which lands on a top surface of each topmost gate layer (12).

7. The 3D CCD memory (10) of claim 6, wherein the contact via (17) passes the other gate layers (12) of the multiple steps (31), and is electrically isolated by a spacer (32) from each of these other gate layers (12).

8. The 3D CCD memory (10) of claim 6 or 7, wherein:
each step (31) a has staircase-like structure comprising multiple sub-steps (41) that spread out into a third direction (y) perpendicular to the first and second direction (z, x), each sub-step (41) comprising one gate layer (12), and gate layers (12) of different sub-steps (41) belonging to different groups (I, II); and
each sub-step (41) of the step (31) is electrically connected by a different contact via (17), which lands on a top surface of the gate layer (12) of said sub-step (41).

9. The 3D CCD memory (10) of one of the claims 1 to 8, wherein:
a set of the plurality of gate layers (12) of the stack (11) is operable as a plurality of clocking phases of the plurality of CCD registers (16), in order to transport charge along the CCD registers (16); and
each group (I, II) of gate layers (12) is associated with a different clocking phase of the plurality of clocking phases.

10. The 3D CCD memory (10) of claim 9 and of claim 6 or 7, wherein the multiple gate layers (12) of each step (31) comprise one gate layer (12) for each of the plurality of clocking phases.

11. The 3D CCD memory (10) of claim 9 or 10, wherein the plurality of contact vias (17) comprises:
a first contact via (17a) connected to a first group (I) of gate layers (12) comprising gate layers (12) associated with a first clocking phase; and
a second contact via (17b) connected to a second group (II) of gate layers (12) comprising gate layers (12) associated with a second clocking phase.

12. The 3D CCD memory (10) of claim 11, wherein the plurality of contact vias (17) further comprises:
a third contact via (17c) connected to a third group of gate layers (12) comprising gate layers (12) associated with a third clocking phase; and/or
one or more further contact vias (17) respectively connected to one or more further groups (I, II) of gate layers (12) respectively comprising gate layers (12) associated with one or more further clocking phases.

13. The 3D CCD memory (10) of one of the claims 1 to 12, wherein the stack (11) has a first region (20) and a second region (21) adjacent to the first region (20), wherein the CCD registers (16) are located in the first region (20) and the contact vias (17) are located in the second region (21).

14. A method (70) for fabricating an integrated three-dimensional, 3D, charge-coupled device, CCD, memory (10), the method (70) comprising:
forming (71) a stack (11) including a plurality of gate layers (12) and spacer layers (13), which are alternatingly arranged one on the other along a first direction (z);
forming (72) a plurality of semiconductor-based channels (14) in the stack (11), wherein the channels (14) form, in combination with the gate layers (12) and one or more gate dielectric layers (15) formed in the stack (11), a plurality of strings of charge storage capacitors operable as a plurality of CCD registers (16); and
forming (73) a plurality of contact vias (17) in the stack (11);
wherein each contact via (17) is associated with one group (I, II) of a plurality of disjoint groups (I, II) of the gate layers (12), and is electrically connected to the gate layers (12) of the group (I, II) it is associated with.

15. The method (70) of claim 14, comprising:
forming, for each contact via (17), a respective opening through the stack (11);
structuring the respective opening, so that the respective opening is smaller for one group (I) of gate layers (12) than for the other groups (II) of gate layers (12);
forming the contact via (17) in the respective opening, wherein the contact via (17) is electrically connected to the gate layers (12) of the group (I, II) it is associated with because of the smaller opening in these gate layers (12), and is electrically isolated from the gate layers (12) of the other groups because of the larger opening in these gate layers (12);
wherein respective openings for different contact vias (17) have the smaller opening in gate layers (12) of different groups (I, II).
